# EUROPÄISCHE PATENTSCHRIFT

(11) **EP 3 185 382 B1**
(45) Veröffentlichungstag und Bekanntmachung des Hinweises auf die Patenterteilung: **04.09.2019**
(21) Anmeldenummer: 16204490.3
(22) Anmeldetag: 15.12.2016
(51) Int. Cl.: H02H 1/00, G01R 31/12, H02B 13/065

(54) **SYSTEM ZUR DIAGNOSE DES TECHNISCHEN BETRIEBSZUSTANDES EINER ELEKTRISCHEN HOCHSPANNUNGS- UND MITTELSPANNUNGSANLAGE**
SYSTEM FOR DIAGNOSING THE OPERATIONAL STATE OF A HIGH VOLTAGE AND MEDIUM VOLTAGE INSTALLATION
SYSTÈME DE DIAGNOSTIC DE L'ÉTAT DE FONCTIONNEMENT D'UNE INSTALLATION ÉLECTRIQUE MOYENNE TENSION ET HAUTE TENSION

(30) Priorität: 17.12.2015 DE 102015122073
(43) Veröffentlichungstag der Anmeldung: 28.06.2017
(73) Patentinhaber: Vogl Electronic GmbH, 94330 Salching (DE)
(72) Erfinder: Vogl, Franz, 94315 Straubing (DE)
(74) Vertreter: Glück Kritzenberger Patentanwälte PartGmbB

(56) Entgegenhaltungen:
- DE-A1-102008 063 682
- US-A- 5 550 629
- LAURI KUMPULAINEN ET AL: "Preemptive Arc Fault Detection Techniques in Switchgear and Controlgear", IEEE TRANSACTIONS ON INDUSTRY APPLICATIONS., Bd. 49, Nr. 4, 1. Juli 2013 (2013-07-01), Seiten 1911-1919, XP055372177, US ISSN: 0093-9994, DOI: 10.1109/TIA.2013.2258314
- M Muhr ET AL: "Experience with optical partial discharge detection", Materials Science-Poland, 1. Januar 2009 (2009-01-01), XP055372180, Gefunden im Internet: URL:http://www.materialsscience.pwr.wroc.p l/bi/vol27no4/articles/ms_20_3muhr.pdf

## Beschreibung

Die vorliegende Erfindung betrifft ein System zur Diagnose des technischen Betriebszustandes einer elektrischen Hochspannungs- und Mittelspannungsanlage gemäß den Merkmalen des Patentanspruches 1. Ein gattungsgemäßes System zur Diagnose des technischen Betriebszustandes einer elektrischen Hochspannungs- und Mittelspannungsanlage mit den Merkmalen des Oberbegriffs des Patentanspruches 1 ist dabei aus der Druckschrift US 5 550 629 A bekannt geworden.

Unter einer elektrischen Hochspannungs- und Mittelspannungsanlage wird vorliegend eine vorzugsweise gasisolierte Schaltanlage (GIS= "Gas Insulated Switchgear") verstanden, die als vollständig gasdicht gekapselte Schaltanlage für Hochspannungs- und Mittelspannungsanwendungen ausgebildet ist und bei der zur Isolierung des zumindest einen elektrischen Innenleiters dieser mit Schwefelhexafluorid (SF6) als Schutzgas umgeben ist. Damit sind, im Gegensatz zu luftisolierten Schaltanlagen, kompakt aufgebaute Schaltanlagen realisierbar, die nur wenig Bauraum benötigen.

Unter elektrischer Hochspannungs- und Mittelspannungsanlage werden vorliegend auch gasisolierte Rohrleitungen (GIL) verstanden, die im Bereich der elektrischen Energietechnik als Übertragungsleitungen für Höchstspannungen, also elektrische Spannungen von über 300 kV, eingesetzt werden. Durch die besondere Konstruktion kann elektrische Leistung mit hohen Spannungen und hohen Strömen auf kleinstem Raum übertragen werden. Daher finden gasisolierte Rohrleitungen unter anderem Anwendung bei der Ausleitung von elektrischer Energie z. B. aus Innenräumen von Schaltanlagen.

In derartigen elektrischen Anlagen, wie insbesondere GIS- bzw. GIL-Anlagen, zur Energieversorgungen kommt es auf Grund von schädigenden Einflüssen auf die hoch- bzw. höchstspannungstragenden Bauteile und Alterungserscheinungen der Isolierungen immer wieder zu Ausfällen. Hauptsächlich werden diese Ausfälle durch Teilentladungen und/oder Störlichtbögen innerhalb der gasdicht gekapselten Schaltanlage verursacht. Teilentladungen bilden dabei die Ursache für Störlichtbögen und können bis zu einem elektrischen Durchschlag führen, falls die betroffene elektrische Schaltanlage nicht rechtzeitig abgeschaltet und/oder gewartet wird. Auf Grund der mit dem Störlichtbogen verbundenen hohen Energiefreisetzung können dabei weitere Bauteile der jeweiligen elektrischen Schaltanlage beschädigt werden, was bis hin zu einem Komplettausfall der jeweiligen elektrischen Schaltanlage führen kann.

Aus der Druckschrift DE 692 06 925 T2 ist eine Lichtdetektionsvorrichtung des Fluoreszenzfasertyps bekannt geworden, die zum Detektieren eines Lumineszenzzustandes für ein Licht geeignet ist, das eine kleine Lichtmenge aufweist.

Weiterhin ist aus der Druckschrift DD 253 716 A1 eine Vorrichtung zur Erfassung und Ortung von Teilentladungen in metallgekapselten Hoch- oder Mittelspannungsschaltanlagen bekannt geworden, die einen Aufnehmer sowie einen Selektivverstärker aufweist. Hierbei wird vorgeschlagen, dass als Messvorrichtung ein resonanzbetriebener elektroakustischer Wandler dem Selektivverstärker vorgeschaltet ist.

Im Hinblick auf eine sichere Energieversorgung ist es wünschenswert, die Entstehung von Betriebsstörungen in derartigen gasisolierten Schaltanlagen oder Rohrleitungen rechtzeitig und schnell erfassen zu können, insbesondere sich anbahnende Fehler, wie insbesondere Teilentladungen sowie Störlichtbögen, vorhersagen zu können. Eine fehlerhafte Funktionsweise aufgrund nicht rechtzeitig erkannter Betriebsstörungen kann mitunter zu schwerwiegenden Netzausfällen ("Blackout") führen.

Es haben sich daher im Stand der Technik verschiedenste Monitoring-, Analyse- oder Diagnosesysteme zur Erfassung des technischen Betriebszustandes von gasisolierten Schaltanlagen oder Rohrleitungen etabliert. Eine bekannte Methode besteht in der Messung elektrischer Stromimpulse und/oder elektromagnetischer Signale, die mit dem Auftreten von Teilentladungen verbunden sind. Die Interpretation dieser Messergebnisse ist unter Praxisbedingungen wegen elektromagnetischer Störungen jedoch häufig schwierig. Außerdem sind diese Messungen sehr aufwendig und erfordern typischerweise den Aufbau geeigneter Mess- und Prüfanlagen vor Ort. Daher erfolgt die Überwachung üblicherweise nur in größeren Zeitabständen oder bei der Vermutung entstehender Schädigungen. Zudem wird die Messempfindlichkeit von elektromagnetischen Umweltstörungen weitergehend begrenzt, so dass Teilentladungen erst in einem späten Stadium, d. h. kurz vor dem Durchbruch als Störlichtbogen, erfasst werden können.

Da Teilentladungen elektrische, akustische als auch optische Signale erzeugen, können diese unterschiedlichen Signale wahlweise messtechnisch erfasst und ausgewertet werden. So hat sich im Stand der Technik ein weiteres optisches Diagnosesystem etabliert, bei dem zur optischen Erfassung eines durch Teilentladung erzeugten Lichtsignals zumindest eine Lichtempfängereinheit mit wenigstens einem faseroptischen Sensor sowie einem Fotomultiplier vorgesehen sind und wobei die Lichtempfängereinheit über eine Übertragungsleitung mit einer Mess- und Auswertelektronik verbunden ist.

Ein optisches Diagnosesystem bietet den erheblichen Vorteil der hohen Empfindlichkeit für entstehende Entladungserscheinungen, wie insbesondere Teilentladungen und/oder Lichtbögen. Mithin werden derartige optische Diagnosesysteme nicht durch Reflexionsvorgänge oder Überlagerungen innerhalb der elektrischen Anlage oder durch Störungen von außen beeinflusst. Problematisch bei derartigen optischen Diagnosesystemen ist jedoch der Umstand, dass das von elektrischen Teilentladungen und/oder Lichtbögen ausgehende Lichtsignal abhängig von der Art des Lichtsignals, also ob es sich um Teilentladung oder einen Lichtbogen handelt, variierende Lichtwellenlängen ab 200nm besitzen kann. Dabei gilt es zusätzlich zu berücksichtigen, dass Teilentladungen hohe Spektralanteile im UV-Bereich und Funken oder Lichtbögen hohe Spektralanteile im IR-Bereich aufweisen. Unter "Lichtbögen" werden im Rahmen der vorliegenden Erfindung Störlichtbögen, Schaltlichtbögen, als auch Prüflichtbögen verstanden. Ein Störlichtbogen, oder auch Fehlerlichtbogen genannt, ist in der elektrischen Energietechnik ein technisch unerwünscht auftretender Lichtbogen zwischen elektrischen Anlagenteilen. Ein Schaltlichtbogen ist ein Lichtbogen, der beim Trennen zweier stromdurchflossener elektrischer Kontakte entsteht. Bei kleinen Strömen treten nur so genannte Abreißfunken oder Schaltfunken auf, die von selbst verlöschen, jedoch die gleiche Ursache haben. Unter einem Prüflichtbogen wird ein Lichtbogen verstanden, der während des Hochspannungstest einer elektrischen Anlage als Prüfüberschlag entstehen kann. Es wurden daher im Stand der Technik optische Diagnosesysteme entwickelt, die entweder zur Erfassung von Teilentladungen oder aber alternativ zur Erfassung von Lichtbögen eingerichtet sind.

Ausgehend vom dargelegten Stand der Technik liegt der Erfindung die Aufgabe zugrunde, ein System zur Diagnose des technischen Betriebszustandes einer elektrischen Hochspannungs- und Mittelspannungsanlage anzugeben, welches sowohl eine optische Erfassung sowohl von Teilentladungen als auch von Lichtbögen ermöglicht. Diese Aufgabe wird ausgehend von den Merkmalen des Oberbegriffs des Patentanspruches 1 durch dessen kennzeichnenden Merkmale gelöst.

Der wesentliche Aspekt des erfindungsgemäßen Systems zur Diagnose des technischen Betriebszustandes einer elektrischen Hochspannungs- und Mittelspannungsanlage gemäß dem Patentanspruch 1 ist darin zu sehen, dass das Diagnosemodul zur optischen Erfassung von Teilentladungen in einem ersten Betriebsmodus sowie zur optischen Erfassung von Lichtbögen in einem zweiten Betriebsmodus ausgebildet ist, wobei das durch die elektrische Entladungserscheinungen erzeugte Lichtsignal abhängig vom jeweiligen Betriebsmodus unterschiedlich verstärkt und mittels der in dem Diagnosemodul integrierten zumindest einen Auswerteeinheit zur Diagnose des technischen Betriebszustandes unterschiedlich ausgewertet wird.

Erfindungsgemäß ist damit das Diagnosemodul sowohl zur Erfassung von Teilentladung als auch zur Erfassung von Lichtbögen ausgebildet, wobei das das durch die elektrische Entladungserscheinung erzeugte Lichtsignal unterschiedlich stark verstärkt wird und damit eine Diagnose des technischen Betriebszustandes einer elektrischen Hochspannungs- und Mittelspannungsanlage mittels eines gemeinsamen Systems sowohl für Teilentladungen als auch für Lichtbögen ermöglichen. Hierdurch kann besonders schnell und effektiv auf den jeweiligen Betriebszustand der elektrischen Anlage geschlossen werden, insbesondere entschieden werden, ob eine Wartung dessen erforderlich ist oder nicht. Erfindungsgemäß wurde hierbei erkannt, dass das Diagnosemodul in seinem jeweiligen Betriebsmodus und/oder seiner jeweiligen optoelektrischen Wandler- und Verstärkereinheit dazu eingerichtet sein muss, sowohl die einerseits sehr schwachen Lichtsignale von Teilentladungen sowie andererseits die im Vergleich dazu sehr viel stärkeren Lichtsignale von Lichtbögen unterschiedlich zu verstärken und unterschiedlich auszuwerten. Neben der an sich bekannten Erfassung von Lichtbögen ermöglicht das neue Diagnosemodul zusätzlich eine Erfassung von Teilentladungen innerhalb des gasisolierten Innenraums der jeweiligen elektrischen Anlage, die einen Aufschluss über den Wartungszustand dessen geben bzw. das Risiko einer Störung der elektrischen Anlage anzeigen.

Weiterhin vorteilhaft wird das Diagnosemodul im Dauerbetrieb im zweiten Betriebsmodus und während des Dauerbetriebs nur für eine vorgegebene, definierbare Zeitdauer, beispielsweise zwischen 5 und 20 Sekunden pro Tag im ersten Betriebsmodus betrieben. Vorteilhaft liegt damit der Schwerpunkt des Diagnosemoduls auf der Erfassung von Lichtbögen und zusätzlich der Überprüfung von Auffälligkeiten im Hinblick auf Teilentladungen innerhalb des Innenraums der elektrischen Anlage.

In einer vorteilhaften Ausführungsvariante wirkt die optische Wandler- und Verstärkereinheit des Diagnosemoduls mit einer Spannungsversorgungseinheit zusammen, mittels der die optoelektrische Wandler- und Verstärkungseinheit mit wenigstens zwei unterschiedlichen Betriebsspannungen beaufschlagbar ist, wobei die Spannungsversorgungseinheit zwischen den mindestens zwei Betriebsspannungen umschaltbar ist. Vorzugsweise wird das Diagnosemodul in dem ersten Betriebsmodus mit der ersten Betriebsspannung der Spannungsversorgungseinheit in dem zweiten Betriebsmodus mit einer zweiten Betriebsspannung der Spannungsversorgungseinheit betrieben.

Zu Verbesserung der Auswertebarkeit der erfassten Messsignale weist das Diagnosemodul eine Anpassungsschaltung mit einem ersten und einem zweiten Anpassungsmesssignalpfad auf, die abhängig vom jeweiligen Betriebsmodus geschaltet sind, und zwar im ersten Betriebsmodus ist der erste Anpassungsmesssignalpfad und im zweiten Betriebsmodus der zweite Anpassungsmesssignalpfad geschaltet. Weiterhin vorteilhaft ist das Diagnosemodul dazu eingerichtet, zwischen dem ersten und dem zweiten Anpassungsmesssignalpfad abhängig vom jeweiligen Betriebsmodus mittels eines Umschalters gesteuert umzuschalten. In einer bevorzugten Ausführungsvariante des Diagnosemoduls weist dieses wenigstens einen Lichtstab auf, der dazu ausgebildet ist, das Lichtsignal wenigstens des Innenraums des Gehäuses zu erfassen und an die zumindest eine optoelektrische Wandler- und Verstärkereinheit zu übertragen.

Die zumindest eine optoelektrische Wandler- und Verstärkereinheit ist dazu ausgebildet, das Lichtsignal abhängig vom jeweiligen Betriebsmodus unterschiedlich zu verstärken und in ein analoges elektrisches Lichtmesssignal umzuwandeln, wobei die optoelektrische Wandler- und Verstärkereinheit als Fotomultiplier realisiert ist.

Vorteilhaft ist die Anpassungsschaltung dazu eingerichtet, das von der zumindest einen optoelektrischen Wandler- und Verstärkereinheit ankommende analoge Lichtmesssignal in Abhängigkeit des Betriebsmodus des Diagnosemoduls in ein aufbereitetes digitales Lichtmesssignal umzuwandeln, das mittels der zumindest einen Auswerteeinheit zur Diagnose des technischen Betriebszustandes in Abhängigkeit des jeweiligen Betriebsmodus unterschiedlich ausgewertet wird, wobei das aufbereitete Lichtmesssignal vorzugsweise im Spannungs-Nulldurchgang der positiven Halbwelle des mit einer Wechselspannung beaufschlagten stromdurchflossenen Innenleiters erfolgt.

Die Ausdrucke "näherungsweise", "im Wesentlichen", "ca." oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:
- Fig. 1: beispielhaft ein stark vereinfachtes, schematisches Blockschaltbild einer Ausführungsvariante eines erfindungsgemäßen Diagnosesystems
- Fig. 2: ein vereinfachtes, schematisches Blockschaltbild eines Diagnosesystems gemäß einer ersten Ausführungsvariante der Erfindung
- Fig. 3a: beispielhaft in einem Diagramm den Verlauf eines aufbereiteten, digitalen Lichtmesssignals
- Fig. 3b: beispielhaft in einem Diagramm den Verlauf eines weiteren aufbereiteten, digitalen Lichtmesssignals
- Fig. 3c: beispielhaft in einem Diagramm den Verlauf eines nochmals weiteren aufbereiteten, digitalen Lichtmesssignals
- Fig. 4a bis d: beispielhaft in unterschiedlichen Diagrammen den unterschiedlichen Verlauf aufbereiteter, digitaler Lichtmesssignale
- Fig. 5: ein vereinfachtes, schematisches Blockschaltbild eines Diagnosesystems gemäß einer weiteren Ausführungsvariante der Erfindung.

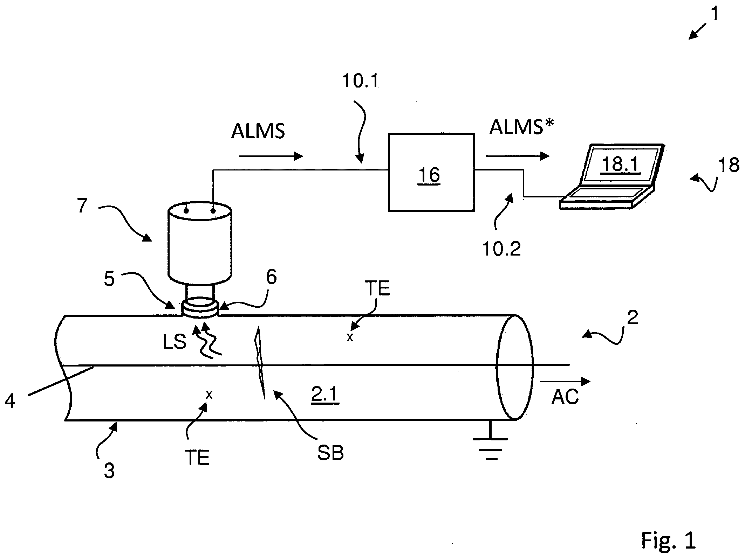

Die Figur 1 zeigt beispielhaft in stark vereinfachter Darstellung ein erfindungsgemäßes System 1 zur Diagnose des technischen Betriebszustandes einer elektrischen Hochspannungs- und Mittelspannungsanlage 2. Dabei kann die elektrische Hochspannungs- und Mittelspannungsanlage 2 als luft- oder gasisolierte Schaltanlage oder Rohrleitung 2 ausgebildet sein, wie sie einem Fachmann aus dem Stand der Technik hinreichend bekannt ist. Insbesondere kann die elektrische Hochspannungs- und Mittelspannungsanlage 2 zudem wenigstens einen Leistungsschalter umfassen.

Derartige elektrische Hochspannungs- und Mittelspannungsanlagen 2 weisen zumindest einen mit vorzugsweise SF6- Gas gefüllten und gasdicht ausgebildeten Innenraum 2.1 auf, der von einem Gehäuses 3 vorzugsweise gasdicht umschlossen ist. Innerhalb des Gehäuses 3, also in dessen wenigstens einem Innenraum 2.1, ist wenigstens ein stromdurchflossener Innenleiter 4 vorgesehen. Sieht die Hochspannungs- und Mittelspannungsanlage 2 dabei einen Leistungsschalter vor, so kann der wenigstens eine Innenleiter 4 über diesen Leistungsschalter zu- und/oder abschaltet werden.

Der stromdurchflossene Innenleiter 4 ist beispielsweise als rotationssymmetrisches Hochspannungskabel ausgebildet, das mit Hochspannung beaufschlagbar ist. In einer Ausführungsvariante kann die als gasisolierte Schaltanlage oder Rohrleitung ausgebildete elektrische Hochspannungs- und Mittelspannungsanlage 2 auch mehrere separierte und jeweils gasdicht zueinander vorgesehene Innenräume 2.1 aufweisen, die entsprechend von dem gemeinsamen Gehäuse 3 oder jeweils einem Gehäuse 3 gasdicht umschlossen sind.

Weiterhin kann die elektrische Hochspannungs- und Mittelspannungsanlage 2 wenigstens einen Anschlussabschnitt, vorzugsweise einen Anschlussflansch 5 je Innenraum 2.1 aufweisen, der an der äußeren Wandung des Gehäuses 3 vorgesehen ist. Der Anschlussflansch 5 umschließt hierbei-zumindest eine Gehäuseöffnung, die zum gasdichten Verschluss des Innenraumes 2.1 mit einem nur schematisch angedeuteten Sichtfenster verschlossen ist. Das Sichtfenster 6 ermöglicht eine direkte und/oder indirekte Erfassung von Lichterscheinungen in dem an sich abgedunkelten Innenraum 2.1 des Gehäuses 2. Das Sichtfenster 6 kann beispielsweise als Schauglas ausgebildet sein, mittels dem zwar eine Sichtverbindung in den jeweiligen Innenraum 2.1, insbesondere zu dem jeweiligen stromdurchflossenen Innenleiter 4, geschaffen wird, jedoch ohne dabei in die innere Atmosphäre des Innenraums 2.1 einzugreifen.

Das erfindungsgemäße System 1 zur Diagnose des technischen Betriebszustandes einer elektrischen Hochspannungs- und Mittelspannungsanlage 2 weist zur optischen Erfassung eines durch elektrische Entladungserscheinungen in zumindest dem Innenraum 2.1 des Gehäuses 3 erzeugten Lichtsignals bzw. Lichtsignale LS ein Diagnosemodul 7 mit zumindest einer optoelektrischen Wandler- und Verstärkereinheit 9, 9a, 9b auf, wobei das Diagnosemodul 7 mit einer Auswerteeinheit 11 zusammenwirkt. Besonderes bevorzugt kann die Auswerteeinheit 11 dabei baulich in dem Diagnosemodul 7 integriert, also Bestandteil des Diagnosemoduls 7, sein. Bei den elektrischen Entladungserscheinungen kann es sich insbesondere um Teilentladungen TE und/oder Lichtbögen LB handeln, welche im gasdichten Innenraum 2.1 das Lichtsignal LS erzeugen bzw. aussenden.

In einer bevorzugten Ausführungsvariante kann auch ein Lichtstab 8 an dem Anschlussflansch 5 vorgesehen sein, um die Lichtsignale LS vom Innenraum 2.1 durch die Wandung des Gehäuses 3 an das Diagnosemodul 7 zu leiten.

Dabei kann das Diagnosemodul 7 zur Eigendiagnose des Systems 1 zur Diagnose des technischen Betriebszustandes der elektrischen Hochspannungs- und Mittelspannungsanlage 2 ein gesteuert betätigbares Leuchtmittel zur Erzeugung eines Lichtsignals LS aufweisen. Insbesondere ist das Leuchtmittel derart an dem Diagnosemodul 7 vorgesehen, dass mittels diesem ein Lichtsignal LS erzeugbar ist, welches über die zumindest einer optoelektrischen Wandler- und Verstärkereinheit 9, 9a, 9b erfassbar ist. Beispielsweise kann das Leuchtmittel dem Bereich des Diagnosemoduls 7 vorgesehen sein, in dem dieses an bzw. mit dem Anschlussflansch 5 verbunden ist, also beispielsweise zwischen dem Lichtstab 8 und der zumindest einer optoelektrischen Wandler- und Verstärkereinheit 9, 9a, 9b.

Bevorzugt kann das Leuchtmittel als Leuchtdiode ausgebildet sein, die zur Erzeugung eines Lichtsignals LS eingerichtet ist. Das Leuchtmittel ist dabei Bestandteil des Systems 1 zur Diagnose des technischen Betriebszustandes der elektrischen Hochspannungs- und Mittelspannungsanlage 2, insbesondere eine in dem Diagnosemodul 7 integrierte Baugruppe, bzw. Bauteil. Bevorzugt kann damit in vorbestimmbaren Zeitintervallen eine Eigendiagnose auf die ordnungsgemäße Betriebstüchtigkeit des Systems 1 zur Diagnose des technischen Betriebszustandes der elektrischen Hochspannungs- und Mittelspannungsanlage 2, insbesondere eine in dem Diagnosemodul 7, durchgeführt werden, in dem mittels des Leuchtmittels ein Leuchtsignal LS erzeugt wird, das dann über die wenigstens eine optoelektrischen Wandler- und Verstärkereinheit 9, 9a, 9b erfasst und weitergehend ausgewertet werden kann.

Das Diagnosemodul 7 ist vorzugsweise ebenfalls lösbar mit dem Anschlussflansch 5 verbunden, beispielweise an diesem angeschraubt, und zwar derart, dass der Lichtstab 8 im gasdichten Innenraum 2.1 entstehende Lichtsignale LS aufnimmt und an die wenigstens eine optoelektrische Wandler- und Verstärkereinheit 9, 9a, 9b des Diagnosemoduls 7 überträgt. Beispielweise kann der vorzugsweise zylinderförmige und mit dem Anschlussflansch 5 verschraubte Lichtstab 8 mit seinem ersten freien stirnseitigen Ende in Richtung des Sichtfensters 6 zeigen, vorzugsweise am Sichtfenster 6 kontaktschlüssig anliegen, um im gasdichten Innenraum 2.1 entstehende Lichtsignale LS aufzunehmen, während der Lichtstab 8 mit seinem zweiten, dem ersten freien Ende gegenüberliegenden, freien Ende kontaktschlüssig an der wenigstens einen optoelektrischen Wandler- und Verstärkereinheit 9, 9a, 9b des Diagnosemoduls 7 anliegt. Bei einem aufgeschraubten Diagnosemodul 7 ist der Innenraum 2.1 des Gehäuses 2 vollständig abgedunkelt, um eine zuverlässige Erfassung insbesondere von elektrischen Entladungserscheinungen mit sehr geringer Leuchtstärke, bzw. Leuchtintensität zu gewährleisten.

Zur Erfassung des oder der vom Lichtstab 8 bereitgestellten Lichtsignals bzw. Lichtsignale LS ist die wenigstens eine optoelektrische Wandler- und Verstärkereinheit 9 als optoelektrisches Bauelement ausgebildet, und zwar in Form eines Fotomultipliers. Ferner ist die optoelektrische Wandler- und Verstärkereinheit 9 bzw. das optoelektrische Bauelement dazu eingerichtet, das vom Lichtstab 8 erfasste Lichtsignal LS unterschiedlich zu verstärken und in ein analoges elektrisches Lichtmesssignal LMS umzuwandeln, das nach einer weiteren Signalverarbeitung mittels einer Auswerteeinheit 11 zur Diagnose des technischen Betriebszustandes unterschiedlich ausgewertet wird. Insbesondere wird das analoge elektrische Lichtmesssignal LMS mittels wenigstens einer mit der zumindest einen optoelektrischen Wandler- und Verstärkungseinheit 9, 9a, 9b zusammenwirkenden Anpassungsschaltung 12, 12a, 12b weiter aufbereitet, die insbesondere in das Diagnosemodul 7 integriert sein kann.

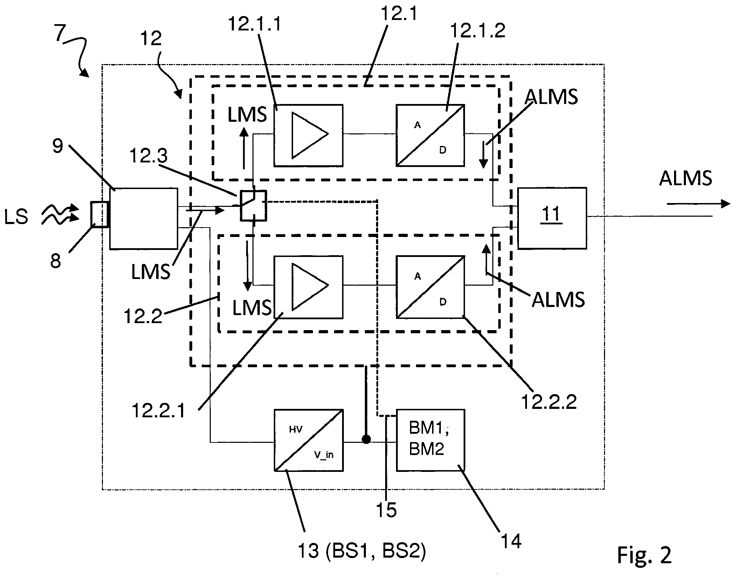

Gemäß der Ausführungsvariante der Figur 2 der Erfindung sieht das Diagnosemodul 7 eine einzige optoelektrische Wandler- und Verstärkereinheit 9 vor, die als Fotomultiplier ausgebildet ist und die mit einer einzigen Anpassungsschaltung 12 zusammenwirkt.

Erfindungsgemäß ist das Diagnosemodul 7 gemäß der ersten Ausführungsvariante der Figur 2 zur optischen Erfassung von Teilentladungen TE in einem ersten Betriebsmodus BM1 sowie zur optischen Erfassung von Lichtbögen LB in einem zweiten Betriebsmodus BM2 ausgebildet, wobei das durch die elektrische Entladungserscheinungen erzeugte Lichtsignal LS abhängig vom jeweiligen Betriebsmodus BM1, BM2 unterschiedlich verstärkt und mittels der in dem Diagnosemodul 7 integrierten Auswerteeinheit 11 zur Diagnose des technischen Betriebszustandes unterschiedlich ausgewertet wird.

Dabei kann die unterschiedliche Verstärkung des Lichtsignals LS für die unterschiedlichen Betriebsmodi BM1 und BM2 in der einen einzigen optoelektrischen Wandler- und Verstärkereinheit 9 erfolgen, indem diese mit einer Spannungsversorgungseinheit 13 zusammenwirkt, mittels der die optische Wandler- und Verstärkungseinheit 9 mit wenigstens zwei unterschiedlichen Betriebsspannungen BS1, BS2 beaufschlagbar ist. Insbesondere kann die Spannungsversorgungseinheit 13 auch als Hochspannungsversorgungseinheit mit einer Spannungsversorgung von bis zu 1500V ausgebildet sein. Besonders bevorzugt ist die Spannungsversorgungseinheit 13 zwischen den mindestens zwei Betriebsspannungen BS1, BS2 umschaltbar ausgebildet. Hierfür kann das Diagnosemodul 7 eine Steuereinheit 14 umfassen, die mit der Spannungsversorgungseinheit 13 in elektrischer Wirkverbindung steht und mittels der die Umschaltung zwischen den beiden Betriebsspannungen BS1, BS2 gesteuert wird. Die Steuereinheit 14 ist mit der Anpassungsschaltung 12 zum Betrieb des Diagnosemoduls im ersten oder zweiten Betriebsmodus BM1, BM2 verbunden, die nachfolgend noch nähergehend erläutert wird.

Dabei kann die eine einzige optoelektrische Wandler- und Verstärkungseinheit 9 in dem ersten Betriebsmodus BM1 zur Erfassung der Teilentladung TE mit einer ersten Betriebsspannung BS1 der Spannungsversorgungseinheit 13 beaufschlagt werden, die vorzugsweise zwischen 400V und 800V gewählt ist. Das Lichtsignal LS wird damit mittels der einen einzigen optoelektrischen Wandler- und Verstärkungseinheit 9 für die Erfassung von Teilentladungen TE in einem ersten Betriebsmodus BM1 mit einer ersten Betriebsspannung BS1 verstärkt.

Weiterhin wird die eine einzige optoelektrische Wandler- und Verstärkungseinheit 9 dieser ersten Ausführungsvariante der Erfindung in dem zweiten Betriebsmodus BM2 zur Erfassung von Lichtbögen LB mit einer zweiten Betriebsspannung BS2 der Spannungsversorgungseinheit 13 beaufschlagt, die vorzugsweise größer als 100V, jedoch deutlich unter 500 V gewählt ist. Damit wird das Diagnosemodul 7 in dem zweiten Betriebsmodus BM2 mit der zweiten Betriebsspannung BS2 betrieben und somit das Lichtsignal LS mittels der optoelektrischen Wandler- und Verstärkungseinheit 9 für die Erfassung von Störlichtbögen SB in einem zweiten Betriebsmodus BM2 mit einer zweiten Betriebsspannung BS2 verstärkt.

Die unterschiedliche Verstärkung des Lichtsignals LS durch die eine einzige optoelektrische Wandler- und Verstärkungseinheit 9 ist dabei abhängig von der angelegten Betriebsspannung BS1, BS2, die mittels der Spannungsversorgungseinheit 13 erzeugt wird. Dabei treffen die Photonen des Lichtsignals LS auf beispielweise eine Photokathode der optoelektrischen Wandler- und Verstärkungseinheit 9 und lösen durch den äußeren photoelektrischen Effekt Elektronen aus deren Oberfläche, wie dies beispielsweise auch bei einer Photozelle der Fall ist. Die freigesetzten Photoelektronen werden in einem elektrischen Feld der optoelektrischen Wandler- und Verstärkungseinheit 9 beschleunigt und treffen auf weitere Elektroden, die insbesondere als Dynoden ausgebildet sein können, aus deren Oberfläche jedes auftreffende Elektron mehrere Sekundärelektronen herausbeschleunigt. Somit nimmt die Anzahl der Elektronen von Dynode zu Dynode exponentiell zu. Damit dies der Fall ist, müssen die Dynoden auf zunehmend positivem Potential liegen. Dies kann realisiert werden, indem die Spannungsversorgungseinheit 13 die Betriebsspannung BS1 oder BS2 über eine Spannungsteilerkette aufteilt. Schlussendlich treffen die Elektronen auf eine Anode der einen einzigen optoelektrischen Wandler- und Verstärkungseinheit 9 und fließen zur Masse hin ab. Dabei erzeugen sie einen Spannungsabfall. Diese Spannung bildet das analoge elektrische Lichtmesssignal LMS, das mittels der mit der einen einzigen optoelektrischen Wandler- und Verstärkungseinheit 9 zusammenwirkenden Anpassungsschaltung 12, die insbesondere in das Diagnosemodul 7 integriert sein kann, weiter aufbereitet wird.

In einer weiteren Ausführungsvariante der Erfindung kann die eine einzige optoelektrische Wandler- und Verstärkungseinheit 9 als Halbleiter - Fotomultiplier bzw. Silizium - Fotomultiplier, im Englischen "SiPM" genannt, ausgebildet sein. Derartige Halbleiter-Fotomultiplier werden dabei typischerweise mit einer Betriebsspannung zwischen 20V und 100V betrieben. Es kann daher in einer weiteren Ausführungsvariante der Erfindung vorgesehen sein, dass die eine einzige optoelektrische Wandler- und Verstärkungseinheit 9 in dem ersten Betriebsmodus BM1 zur Erfassung der Teilentladung TE mit einer ersten Betriebsspannung BS1 der Spannungsversorgungseinheit 13 beaufschlagt, die vorzugsweise bis zu 100V beträgt. Weiterhin kann in dieser Ausführungsvariante der Erfindung vorgesehen sein, dass die eine einzige optoelektrische Wandler- und Verstärkungseinheit 9 in dem zweiten Betriebsmodus BM2 zur Erfassung von Lichtbögen LB mit einer zweiten Betriebsspannung BS2 der Spannungsversorgungseinheit 13 beaufschlagt, die vorzugsweise größer als 20V, jedoch deutlich unter 100 V gewählt ist.

Besonders bevorzugt ist die Anpassungsschaltung 12 dazu eingerichtet, das von der optoelektrischen Wandler- und Verstärkungseinheit 9 bereitgestellte analoge elektrische Lichtmesssignal LMS in Abhängigkeit der elektrischen Entladungserscheinung, also einer Teilentladung TE oder eines Lichtbogens LB, und damit in Abhängigkeit des jeweiligen Betriebsmodus BM1, BM2 des Diagnosemoduls 7, in ein aufbereitetes digitales Lichtmesssignal ALMS umzuwandeln.

In derer ersten Ausführungsvariante der Figur 2 kann die Anpassungsschaltung 12 dabei wenigstens einen ersten Anpassungsmesssignalpfad 12.1 für die Aufbereitung in ein digitales Lichtmesssignal ALMS eines von Teilentladungen TE erzeugten und mittels der einen einzigen optoelektrischen Wandler- und Verstärkungseinheit 9 verstärkten Lichtmesssignals LMS sowie einen zweiten Anpassungsmesssignalpfad 12.2 für die Aufbereitung in ein digitales Lichtmesssignal ALMS eines von Lichtbögen LB erzeugten und mittels der einen einzigen optoelektrischen Wandler- und Verstärkungseinheit 9 verstärkten Lichtmesssignals LMS aufweisen.

Dabei können die beiden Anpassungsmesssignalpfade 12.1 sowie 12.2 in Abhängigkeit des jeweiligen Betriebsmodus BM1 sowie BM2 mittels der Steuereinheit 14 des Diagnosemoduls 7 gesteuert umgeschaltet werden und zwar derart, dass der erste Anpassungsmesssignalpfad 12.1 im ersten Betriebsmodus BM1 beschaltet ist, während der zweite Anpassungsmesssignalpfad 12.2 im zweiten Betriebsmodus BM2 beschaltet ist. Zur Umschaltung zwischen den beiden Anpassungsmesssignalpfaden 12.1, 12.2 kann die Anpassungsschaltung 12 einen Umschalter 12.3 aufweisen, der über eine Steuerleitung 15 mittels der Steuereinheit 14 des Diagnosemoduls 7 gesteuert umschaltbar ausgebildet ist.

Abhängig vom gewählten Betriebsmodus BM1, BM2 wird die eine einzige optoelektrische Wandler- und Verstärkungseinheit 9 mit einer unterschiedlichen Betriebsspannung BS1, BS2 beaufschlagt sowie der erste oder zweite Anpassungsmesssignalpfad 12.1, 12.2 der Anpassungsschaltung 12 durch den Umschalter 12.3 freigeschaltet. Besonders vorteilhaft wird das Diagnosemodul 7 im Dauerbetrieb, d.h. ganztätig und ohne Unterbrechung (24 Stunden am Tag, 7 Tage die Woche, mindestens 52 Wochen im Jahr) im zweiten Betriebsmodus BM2, also zur optischen Erfassung von Lichtbögen LB, betrieben, wobei während des Dauerbetriebs vorzugsweise dieser täglich für eine kurze Zeitdauer unterbrochen wird, beispielsweise einem Zeitraum zwischen 5 und 20 Sekunden, in dem das Diagnosemodul 7 im ersten Betriebsmodus BM1, also zur optischen Erfassung von Teilentladungen TE betrieben wird. Gemäß dieser Ausführungsvariante ist das Diagnosemodul 7 damit im Dauerbetrieb ständig eingeschaltet und die optoelektrische Wandler- und Verstärkungseinheit 9 mit der zweiten Betriebsspannung BS2 beaufschlagt - also quasi online - zur optischen Erfassung von Lichtbögen LB im zweiten Betriebsmodus BM2.

Gemäß einer alternativen, nicht nähergehend in den Figuren dargestellten Ausführungsvariante der Erfindung kann das erfindungsgemäße Diagnosemodul 7 auch zur Erfassung von Lichtbögen LB offline im zweiten Betriebsmodus BM2 betrieben werden - bei der es damit nicht notwendig ist, die optoelektrische Wandler- und Verstärkungseinheit 9 zur Erfassung von Lichtbögen LB dauerhaft mit der zweiten Betriebsspannung BS2 zu beaufschlagen.

Das erfindungsgemäße Diagnosemodul 7 befindet sich in dieser Ausführungsvariante im Dauerbetrieb vielmehr in einer Art Stand-by-Modus. Es ist dabei im Stand der Technik üblich und dem einschlägigen Fachmann auch bekannt, dass derartige elektrische Hochspannungs- und Mittelspannungsanlage 2 einen Schutzschalter aufweisen, der im Falle einer durch einen Lichtbogen LB verursachten Schutzanregung einen Schaltbefehl zum Freischalten eines diesem zugeordneten Leistungsschalters weiterleitet. Dadurch kann ein entsprechender Gasraum der elektrischen Hochspannungs- und Mittelspannungsanlage 2 strom- und spannungslos, also freigeschaltet, werden. Diese Schutzanregung für den Leistungsschalter kann beispielweise über ein Relais zum Zuschalten, also als Power-up-Signal, der Versorgungsspannung für das Diagnosemodul 7 in den zweiten Betriebsmodus BM2 und der zweiten Betriebsspannung BS2, also zur Erfassung eines Lichtbogens LB, verwendet werden.

Auch wenn sich damit zum eigentlichen Zeitpunkt des Lichtbogens LB das Diagnosemodul 7 noch im Stand-by-Modus befindet, und erst durch die Schutzanregung ein Power-up-Signal zum Betrieb in dem zweiten Betriebsmodus BM2 erfährt, so hat sich gezeigt, dass auch noch zu diesem Zeitpunkt, also insbesondere bis zu fünf Minuten nach dem eigentlichen Lichtbogen LB, Lichtsignale als Signalimpulse SI in Form von "Nachrauschen" in der optoelektrischen Wandler- und Verstärkungseinheit 9 erzeugt werden.

Unter "Nachrauschen" werden im Rahmen der vorliegenden Erfindung durch einen Lichtbogen LB in der optoelektrische Wandler- und Verstärkungseinheit 9 verursachte digitale Lichtmesssignale ALMS bzw. Signalimpulse SI verstanden, die noch bis zu beispielsweise fünf Minuten nach dem eigentlichen Lichtbogen LB in der optoelektrischen Wandler- und Verstärkungseinheit 9 erzeugt werden und die eine Lichtsignalstärke aufweisen, die ein in der Auswerteeinheit 11 abgespeichert hinterlegtes Referenzlichtsignal RLS überschreiten. Hierfür kann vorgesehen sein, dass die Lichtsignalstärke des aufbereiteten digitalen Lichtmesssignal ALMS mit einem in der Auswerteeinheit 11 abgespeichert hinterlegten Referenzlichtsignal RLS verglichen wird und nur bei Überschreiten der Lichtsignalstärke des Referenzlichtsignals RLS eine Auswertung in der Auswerteeinheit 11 erfolgt. Damit kann das Diagnosemodul 7 zur Erfassung von Lichtbögen LB auch im Stand-By-Modus betrieben werden und beispielsweise täglich für eine kurze Zeitdauer mit einer ersten Betriebsspannung BS1 beaufschlagt werden, beispielsweise einem Zeitraum zwischen 5 und 20 Sekunden, in dem das Diagnosemodul 7 im ersten Betriebsmodus BM1, also zur optischen Erfassung von Teilentladungen TE betrieben wird.

Dabei kann der erste Anpassungsmesssignalpfad 12.1 eine erste Signalkonditionierungseinheit 12.1.1 sowie eine erste Analog-Digital-Wandlereinheit 12.1.2 aufweisen. Die erste Signalkonditionierungseinheit 12.1.1 ist beispielsweise dazu eingerichtet, eine Signalverstärkung sowie Impulsverlängerung des analogen elektrischen Lichtmesssignals LMS zu erzeugen, das anschließend mittels der ersten Analog-Digital-Wandlereinheit 12.1.2 in das aufbereitet digitale Lichtmesssignal ALMS umgewandelt wird. Insbesondere kann die erste Signalkonditionierungseinheit 12.1.1 für eine Signalverstärkung sowie Impulsverlängerung eines analogen elektrischen Lichtmesssignals LMS von Teilentladungen TE im Bereich von Mikrosekunden µs bis Nanosekungen ns ausgebildet sein. Der erste Anpassungsmesssignalpfad 12.1 ist zur Umwandlung des analogen elektrischen Lichtmesssignals LMS des von einer Teilentladung TE erzeugten Lichtsignals LS in das aufbereitete digitale Lichtmesssignal ALMS ausgebildet, so dass die gemessenen Lichtsignale LS in eine Folge von Signalimpulsen SI umgesetzt und an die in dem Diagnosemodul 7 integrierte Auswerteeinheit 11 übertragen werden

Dem gegenüber umfasst der zweite Anpassungsmesssignalpfad 12.2 eine zweite Signalkonditionierungseinheit 12.2.1 sowie eine zweite Analog-Digital-Wandlereinheit 12.2.2. Die zweite Signalkonditionierungseinheit 12.2.1 ist beispielsweise dazu eingerichtet, eine Signalverstärkung sowie Impulsverlängerung des analogen elektrischen Lichtmesssignals LMS zu erzeugen, das anschließend mittels der zweiten Analog-Digital-Wandlereinheit 12.2.2 in das aufbereitet digitale Lichtmesssignal ALMS umgewandelt wird. Insbesondere kann die zweite Signalkonditionierungseinheit 12.1.2 für eine Signalverstärkung sowie Impulsverlängerung eines analogen elektrischen Lichtmesssignals LMS von Lichtbögen LB im Bereich von Millisekunden ms bis Mikrosekunden µs ausgebildet sein. Somit ist der zweite Anpassungsmesssignalpfad 12.2 letztlich dazu ausgebildet, die ankommenden analogen elektrischen Lichtmesssignale LMS des von einem Lichtbogen LB erzeugten Lichtsignals LS in aufbereitete digitale Lichtmesssignale ALMS umzuwandeln, so dass die gemessenen Lichtsignale LS in eine Folge von Signalimpulsen SI umgesetzt und an die in dem Diagnosemodul 7 integrierte Auswerteeinheit 11 übertragen werden.

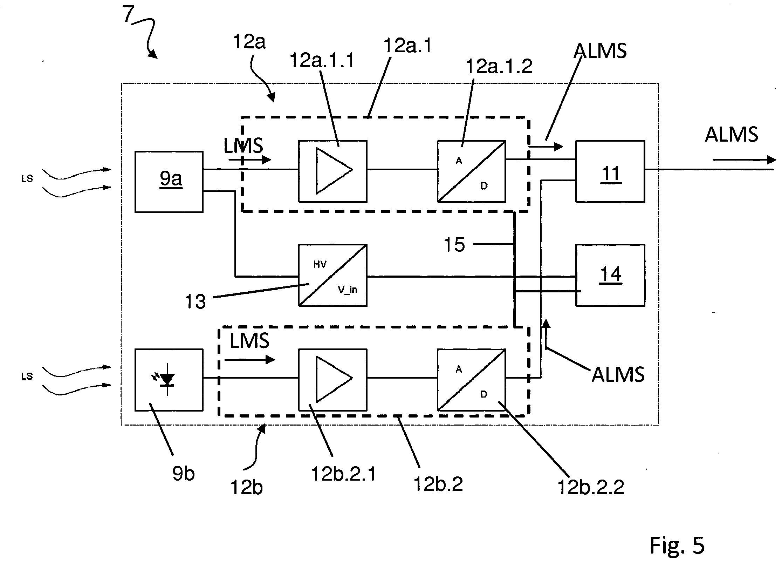

Gemäß der in Figur 5 dargestellten zweiten Ausführungsvariante der Erfindung sieht das System zur Diagnose des technischen Betriebszustandes einer elektrischen Hochspannungs- und Mittelspannungsanlage 2 vor, dass das Diagnosemodul 7 zur optischen Erfassung von Teilentladungen TE mittels einer ersten optoelektrischen Wandler- und Verstärkereinheit 9a sowie zur optischen Erfassung von Störlichtbögen SB mittels einer zweiten optoelektrischen Wandler- und Verstärkereinheit 9b ausgebildet ist, wobei das durch die elektrische Entladungserscheinungen erzeugte Lichtsignal LS in den beiden optoelektrischen Wandler- und Verstärkereinheit 9a, 9b unterschiedlich verstärkt und mittels der zumindest einen Auswerteeinheit 11 zur Diagnose des technischen Betriebszustandes unterschiedlich ausgewertet wird.

Gemäß der zweiten Ausführungsvariante der Figur 5 sieht das Diagnosemodul 7 damit im Unterschied zur Ausführungsvariante der Figur 2 eine erste und eine zweite optoelektrische Wandler- und Verstärkereinheit 9a und 9b vor, wobei die erste optoelektrische Wandler- und Verstärkereinheit 9a insbesondere als Fotomultiplier und die zweite optoelektrische Wandler- und Verstärkereinheit 9b insbesondere als Fotodiode ausgebildet sein kann. Besonders bevorzugt werden dabei beide optoelektrischen Wandler- und Verstärkereinheiten 9a und 9b des Diagnosemoduls 7 an einem gemeinsamen Anschlussflansch 5 der elektrischen Hochspannungs- und Mittelspannungsanlage 2 vorgesehen.

Das Diagnosemodul 7 umfasst hierfür eine erste und eine zweite Anpassungsschaltung 12a, 12b, wobei die erste Anpassungsschaltung 12a mit der ersten optoelektrischen Wandler- und Verstärkungseinheit 9a zusammenwirkt und das mittels der optoelektrischen Wandler- und Verstärkungseinheit 9a erfasste analoge elektrische Lichtmesssignal LMS weiter aufbereitet, während die zweite Anpassungsschaltung 12b mit der zweiten optoelektrischen Wandler- und Verstärkungseinheit 9b zusammenwirkt und das mittels der zweiten optoelektrischen Wandler- und Verstärkungseinheit 9b erfasste analoge elektrische Lichtmesssignal LMS weiter aufbereitet.

Insbesondere ist damit die erste Anpassungsschaltung 12a dazu eingerichtet, das von der ersten optoelektrischen Wandler- und Verstärkungseinheit 9a bereitgestellte analoge elektrische Lichtmesssignal LMS einer elektrischen Entladungserscheinung in Form einer Teilentladung TE in ein aufbereitetes digitales Lichtmesssignal ALMS umzuwandeln, während die die zweite Anpassungsschaltung 12b dazu eingerichtet, das von der zweiten optoelektrischen Wandler- und Verstärkungseinheit 9b bereitgestellte analoge elektrische Lichtmesssignal LMS einer elektrischen Entladungserscheinung in Form eines Lichtbogens LB in ein aufbereitetes digitales Lichtmesssignal ALMS umzuwandeln.

In der zweiten Ausführungsvariante der Figur 5 kann die erste Anpassungsschaltung 12a dabei einen Anpassungsmesssignalpfad 12a.1 für die Aufbereitung in ein digitales Lichtmesssignal ALMS eines von Teilentladungen TE erzeugten und mittels der ersten optoelektrischen Wandler- und Verstärkungseinheit 9a verstärkten Lichtmesssignals LMS aufweisen. Weiterhin kann die zweite Anpassungsschaltung 12b einen Anpassungsmesssignalpfad 12b.1 für die Aufbereitung in ein digitales Lichtmesssignal ALMS eines von Lichtbögen LB erzeugten und mittels der zweiten optoelektrischen Wandler- und Verstärkungseinheit 9b verstärkten Lichtmesssignals LMS aufweisen.

Dabei können die beiden Anpassungsmesssignalpfade 12a.1 sowie 12b.2 der ersten und zweiten Anpassungsschaltung 12a, 12b mittels der Steuereinheit 14 des Diagnosemoduls 7 gesteuert beschaltet, d.h. zu- und abgeschaltet, werden. Hierfür kann die Steuereinheit 14 über Steuerleitungen 15 elektrisch mit der ersten und zweiten Anpassungsschaltung 12a, 12b verbunden sein. Insbesondere kann dabei vorgesehen sein, dass die erste optoelektrische Wandler- und Verstärkungseinheit 9a zur Erfassung der Teilentladung TE mit einer ersten Betriebsspannung BS1 der Spannungsversorgungseinheit 13 beaufschlagt, also betrieben, wird, die vorzugsweise zwischen 400V und 800V gewählt ist. Das Lichtsignal LS wird damit mittels der ersten optoelektrischen Wandler- und Verstärkungseinheit 9a für die Erfassung von Teilentladungen TE mit einer ersten Betriebsspannung BS1 verstärkt.

Es kann dabei insbesondere vorgesehen sein, dass bei dem Diagnosemodul 7 im Dauerbetrieb, d.h. ganztätig und ohne Unterbrechung (24 Stunden am Tag, 7 Tage die Woche, mindestens 52 Wochen im Jahr) die zweite Anpassungsschaltung 12b zur optischen Erfassung von Lichtbögen LB beschaltet ist, wobei während des Dauerbetriebs vorzugsweise dieser täglich für eine kurze Zeitdauer, beispielsweise einem Zeitraum zwischen 5 und 20 Sekunden, die erste Anpassungsschaltung 12a zur optischen Erfassung von Teilentladungen TE parallel dazu geschaltet wird. In anderen Worten sind damit für eine kurze Zeitdauer beide Anpassungsschaltungen, also die ersten als auch die zweite Anpassungsschaltung 12a, 12b beschaltet, d.h. in Betrieb.

Dabei kann der Anpassungsmesssignalpfad 12a.1 der ersten Anpassungsschaltung 12a eine erste Signalkonditionierungseinheit 12a.1.1 sowie eine erste Analog-Digital-Wandlereinheit 12a.1.2 aufweisen. Die erste Signalkonditionierungseinheit 12a.1.1 ist beispielsweise dazu eingerichtet, eine Signalverstärkung sowie Impulsverlängerung des analogen elektrischen Lichtmesssignals LMS zu erzeugen, das anschließend mittels der ersten Analog-Digital-Wandlereinheit 12a.1.2 in das aufbereitet digitale Lichtmesssignal ALMS umgewandelt wird. Insbesondere kann die erste Signalkonditionierungseinheit 12a.1.1 für eine Signalverstärkung sowie Impulsverlängerung eines analogen elektrischen Lichtmesssignals LMS von Teilentladungen TE im Bereich von Mikrosekunden µs bis Nanosekungen ns ausgebildet sein. Der Anpassungsmesssignalpfad 12a.1 der ersten Anpassungsschaltung 12a ist zur Umwandlung des analogen elektrischen Lichtmesssignals LMS des von einer Teilentladung TE erzeugten Lichtsignals LS in das aufbereitete digitale Lichtmesssignal ALMS ausgebildet, so dass die gemessenen Lichtsignale LS in eine Folge von Signalimpulsen SI umgesetzt und an die in dem Diagnosemodul 7 integrierte Auswerteeinheit 11 übertragen werden

Dem gegenüber umfasst der Anpassungsmesssignalpfad 12b.2 der zweiten Anpassungschaltung 12b eine zweite Signalkonditionierungseinheit 12b.2.1 sowie eine zweite Analog-Digital-Wandlereinheit 12b.2.2. Die zweite Signalkonditionierungseinheit 12b.2.1 ist beispielsweise dazu eingerichtet, eine Signalverstärkung des analogen elektrischen Lichtmesssignals LMS zu erzeugen, das anschließend mittels der zweiten Analog-Digital-Wandlereinheit 12b.2.2 in das aufbereitet digitale Lichtmesssignal ALMS umgewandelt wird. Insbesondere kann die zweite Signalkonditionierungseinheit 12b.2.1 für eine Signalverstärkung eines analogen elektrischen Lichtmesssignals LMS von Lichtbögen LB im Bereich von Millisekunden ms bis Mikrosekunden µs ausgebildet sein. Somit ist der Anpassungsmesssignalpfad 12b.2 der zweiten Anpassungsschaltung 12b letztlich dazu ausgebildet, die ankommenden analogen elektrischen Lichtmesssignale LMS des von einem Lichtbogen LB erzeugten Lichtsignals LS in aufbereitete digitale Lichtmesssignale ALMS umzuwandeln, so dass die gemessenen Lichtsignale LS in eine Folge von Signalimpulsen SI umgesetzt und an die in dem Diagnosemodul 7 integrierte Auswerteeinheit 11 übertragen werden.

Wie insbesondere aus der Figur 1 ersichtlich, kann die Auswerteeinheit 11 mittels einer ersten Übertragungsleitung 10.1, die als serielle Schnittstelle ausgebildet sein kann, mit einer Schnittstelleneinheit 16 verbunden sein, in der das aufbereitete digitale Lichtmesssignal ALMS in ein optisches, aufbereitetes Lichtmesssignal ALMS* gewandelt wird und mittels einer zweiten Übertragungsleitung 10.2, die insbesondere als optische Übertragungsleitung, beispielsweise als Lichtwellenleiter, ausgebildet sein kann an eine Rechnereinheit 18 mit wenigstens einer Anzeigeeinheit 18.1 übertragen wird.

Hierbei kann die Auswerteeinheit lldazu ausgebildet sein, die Anzahl der Signalimpulse SI und/oder die Stärke, also insbesondere die Amplitudenstärke A, des aufbereiteten digitalen Lichtmesssignals ALMS als ein Maß für die Lichtenergie bzw. Lichtintensität des erfassten Lichtsignals LS auszuwerten und somit die im Innenraum 2.1 der elektrischen Hochspannungs- und Mittelspannungsanlage 2 vorhandene Lichtenergiemenge zu ermitteln, die auf elektrische Entladungserscheinungen zurückzuführen ist und damit einen direkten Rückschluss auf vorhandene Lichtbögen LB und/oder Teilentladungen TE zulässt. Weiterhin kann die Auswerteeinheit 11 dazu ausgebildet sein, die Zeitdauer Δt eines durch elektrische Entladungserscheinungen erzeugten Lichtsignals LS, also die Zeitdauer Δt, in der elektrische Entladungserscheinung ein Lichtsignal LS aussenden, auszuwerten und daraus zu ermitteln, ob, und wenn ja, um welche Art von technischen Betriebsstörungen, also Lichtbogen LB und/oder Teilentladung TE, es sich bei dem erzeugten Lichtsignals LS handelt.

Insbesondere ist dafür die Auswerteeinheit 11 dazu ausgebildet, eine Zeitdauer Δt im Bereich von Nanosekunden ns bis Millisekunden ms des erzeugten Lichtsignals LS auszuwerten, um daraus einen direkten Rückschluss auf die Art des vorhandenen Lichtbogens LS und/oder Teilentladung TE zu ermitteln. Weiterhin kann die Auswerteeinheit 11 dazu ausgebildet sein, ein abhängig vom jeweiligen Betriebsmodus BM1, BM2 mittels der Anpassungsschaltung 12 bzw. abhängig von der beschalteten ersten oder zweiten Anpassungsschaltung 12a, 12b aufbereitetes digitales Lichtmesssignal ALMS einer Bandbreite einer Intensität I des durch die elektrische Entladungserscheinung erzeugten Lichtsignals LS von 1 bis 10⁻⁹ auszuwerten. Das in der Auswerteeinheit llausgewertete, aufbereitete digitale Lichtmesssignal ALMS kann beispielweise auch ein elektrisches oder optisches Signal mit einer Spannungs- oder Stromamplitude A sein.

Die Auswertung in der Auswerteeinheit lldes aufbereiteten, digitalen Lichtmesssignals ALMS kann beispielweise für einen bestimmten, vordefinierbaren, Zeitraum und/oder Zeitpunkt und/oder Zeitdauer erfolgen. Besonders vorteilhaft ist die Steuereinheit 14 des Diagnosemoduls 7 dazu eingerichtet, in Abhängigkeit des vordefinierten Auswerteintervalls den gewünschten Betriebsmodus BM1, BM2 zu schalten, hierdurch wird vom Betriebsmodus "Erfassung von Lichtbögen LB" auf den alternativen Betriebsmodus "Erfassung von Teilentladungen TE" umgeschaltet.

In einer bevorzugten Ausführungsvariante ist die Signalerfassung des Diagnosemoduls 7 und/oder die Signalauswertung mittels der Auswerteeinheit 11 mit an den Stromfluss durch den Innenleiter 4 der elektrischen Hochspannungs- oder Mittelspannungsanlage 2 angepasst, erfolgt vorzugsweise synchron hierzu. Wird der stromdurchflossene Innenleiter 4 mit einer Wechselspannung AC beaufschlagt, so kann beispielsweise die Signalsauswertung im Nulldurchgang der Wechselspannung AC der positiven Halbwelle erfolgen. Wird der stromdurchflossene Innenleiter 4 hingegen mit einer Gleichspannung DC beaufschlagt, so kann die Signalauswertung als Aufsummierung, bzw. Kumulation, der einzelnen aufbereiteten, digitalen Lichtmesssignale ALMS bzw. Signalimpulse SI über die Zeit t erfolgen.

In einer bevorzugten Ausführungsvariante kann vorgesehen sein, dass die Lichtsignalstärke des aufbereiteten digitalen Lichtmesssignal ALMS mit einem in der Auswerteeinheit 11 abgespeichert hinterlegten Referenzlichtsignal RLS verglichen wird und nur bei Überschreiten der Lichtsignalstärke des Referenzlichtsignals RLS eine Auswertung in der Auswerteeinheit 11 erfolgt.

Besonders bevorzugt ist die Auswerteeinheit 11 des Diagnosemoduls 7 mit einer Rechnereinheit 18 verbunden, die insbesondere dazu eingerichtet ist, softwarebasiert grafische Auswertungen in Form von Diagrammen an einer Anzeigeeinheit 18.1 anzuzeigen.

In einer Ausführungsvariante erfolgt die Diagnose des technischen Betriebszustandes von möglichen Teilentladungen TE in der Auswerteeinheit 11 in einem mittels der Anzeigeeinheit 18.1 der Rechnereinheit 18 dargestellten Diagramm, in dem vorzugsweise der sinusförmige Phasenwinkelverlauf ϕ der Spannung V des stromdurchflossenen Innenleiters 4 sowie beispielhaft die erfassten aufbereiteten, digitalen Lichtmesssignale ALMS bzw. Signalimpulse SI für die Phase 1 darstellbar sind.

In einer weiteren Ausführungsvariante erfolgt die Diagnose des technischen Betriebszustandes von möglichen Lichtbögen LB und/oder Teilentladungen TE in der Auswerteeinheit 11 in einem mittels der Anzeigeeinheit 18.1 der Rechnereinheit 18 dargestellten Diagramm, in dem vorzugsweise die Amplitude der Intensität I des aufbereiteten, digitalen Lichtmesssignals ALMS bzw. Signalimpulse SI über die Zeitdauer Δt dargestellt sind.

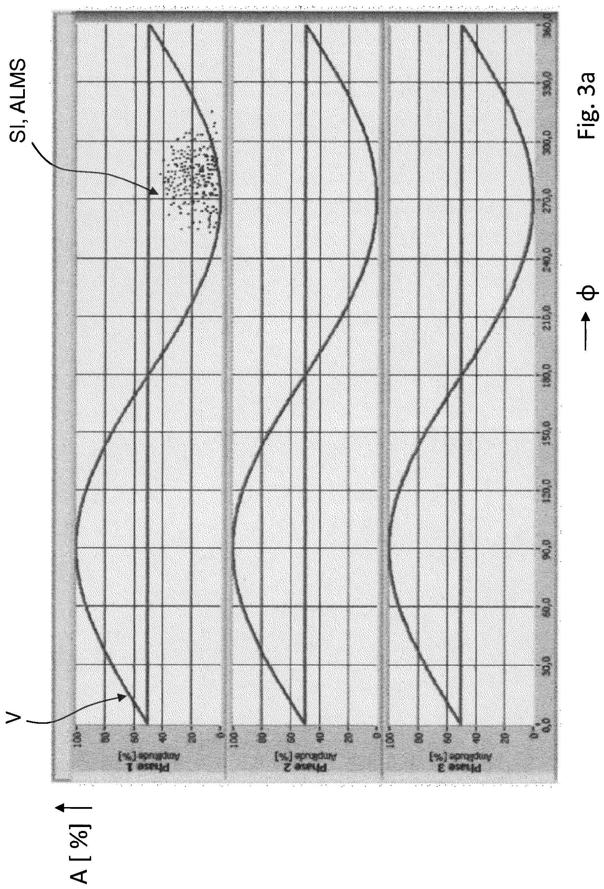

Beispielhaft sind in den Figuren 3a bis c drei unterschiedliche Arten von Teilentladungen TE in dem jeweiligen Diagramm als mögliche Auswertung mittels der Auswerteeinheit 11 dargestellt. Entlang der jeweilige X-Achse ist der Phasenwinkel ϕ aller drei Phasen 1 bis 3 des Spannungsverlaufes V des stromdurchflossenen Innenleiters 4 aufgetragen, wobei die Y-Achse die jeweilige Amplitude A der Spannung V in [%] darstellt. Weiterhin ist der Sinusverlauf der Spannung V des stromdurchflossenen Innenleiters 4 einer jeden der drei Phasen 1 bis 3 auf den Spannungs-Nulldurchgang synchronisiert abgebildet.

Ferner dargestellt sind in den Figuren 3a bis 3c die insbesondere mittels des ersten Anpassungsmesssignalpfads 12.1 aufbereiteten Signalimpulse SI, bzw. aufbereiteten, digitalen Lichtmesssignale ALMS. Die Signalimpulse SI sind in den Diagrammen der Figuren 3a bis 3c als Punktmenge abgebildet, wobei ein jeder einzelne Punkt für einen einzigen Signalimpuls SI, d. h. eine einzelne Teilentladung TE, steht. Mithin kann somit aus der Anzahl der Punkte bzw. Teilentladungen TE, die jeweils einen Signalimpuls SI repräsentierten, auf die Anzahl der Teilentladungen TE im Innenraum 2.1 der Hochspannungs- oder Mittelspannungsanlage 2 rückgeschlossen werden, wobei darüber hinaus die Anordnung der Signalimpulse SI in Bezug auf den Signalverlauf zusätzlich ausgewertet wird.

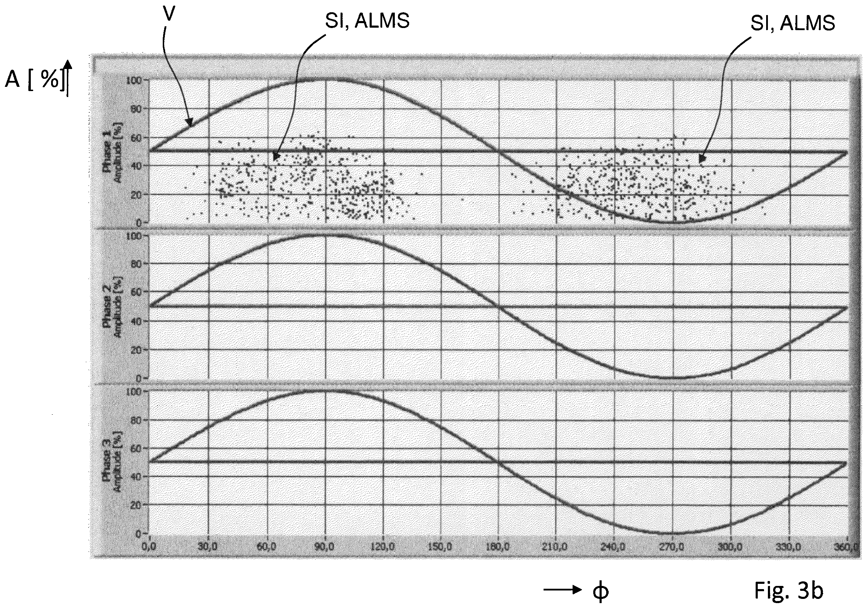

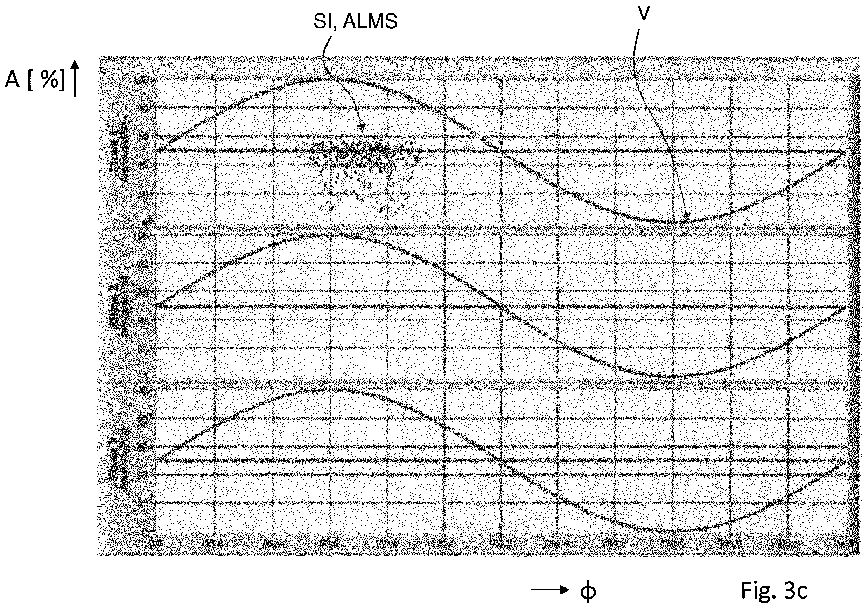

Besonders vorteilhaft wird damit sowohl eine qualitative als auch quantitative Bestimmung der Teilentladung TE ermöglicht. Weiterhin können über die Synchronisation der optischen Erfassung der Teilentladung TE mit dem Spannungs-Nulldurchgang des stromdurchflossenen Innenleiters 4 Rückschlüsse auf die Fehlerursache bzw. auf die Art der Teilentladung TE gezogen werden. Werden die Teilentladungen TE, wie beispielsweise in der Figur 3a grafisch dargestellt, in der negativen Halbwelle des Sinusverlaufes der Spannung V des stromdurchflossenen Innenleiters 4 erfasst, so kann daraus rückgeschlossen werden, dass die Teilentladung TE an einem Hochspannungspotential tragenden Bauteil stattfindet, während es sich bei der Teilentladung TE der Figur 3c um wenigstens ein Teil auf Massepotential handelt. In diesen Fall werden die in der positiven Halbwelle des Sinusverlaufes der Spannung V des stromdurchflossenen Innenleiters 4 erfasst. Dem gegenüber kann aus der Erfassung von Teilentladung TE sowohl in der negativen als auch in der positiven Halbwelle gemäß der Figur 3b geschlossen werden, dass es sich um ein "springendes Teilchen" im Innenraum 2.1 der Hochspannungs- oder Mittelspannungsanlage 2 handelt.

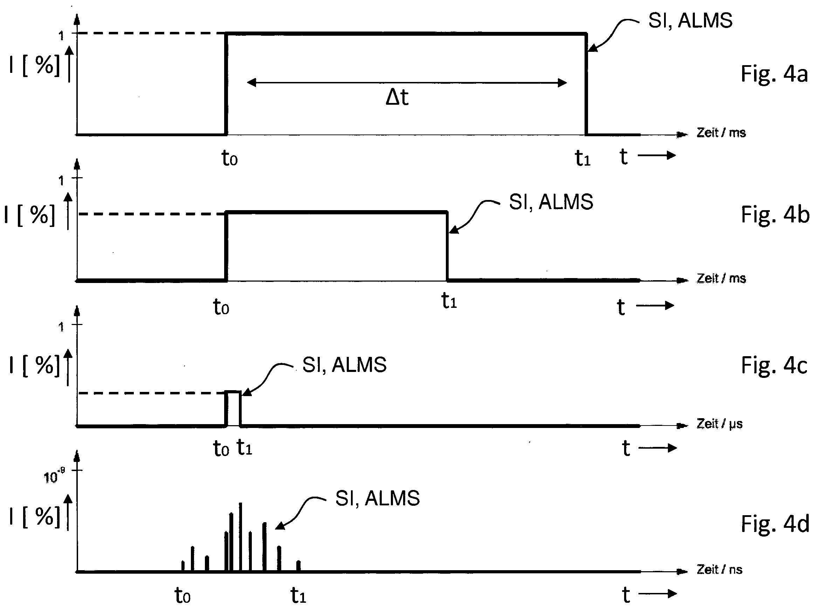

In den Figuren 4a bis 4c sind beispielhaft drei unterschiedliche Arten von Lichtbögen LB in dem jeweiligen Diagramm als mögliche Auswertung mittels der Auswerteeinheit 11 dargestellt, die beispielweise über eine Anzeigeeinheit 18.1 zur Anzeige gebracht werden können.

Insbesondere zeigt die Figur 4a das Diagramm eines als Störlichtbogen ausgebildeten Lichtbogens LB, die Figur 4b das Diagramm eines Lichtbogens LB, der als Schaltlichtbogen ausgebildet ist, und die Figur 4c das Diagramm eines Lichtbogens LB eines Prüf-Lichtbogens. In Figur 4d wiederum ist das Diagramm einer Teilentladung TE gezeigt.

Entlang der jeweiligen X-Achsen ist die Zeit t in unterschiedlichen Zeiteinheiten, nämlich Millisekunden ms in den Figuren 4a und 4b, Mikrosekunden µs in der Figur 4c, und Nanosekunden ns in der Figur 4d, angetragen, während die Y-Achse die Intensität I des aufbereiteten digitalen Lichtmesssignals ALMS, bzw. der aufbereiteten Signalimpulse SI in [%] darstellt.

Der jeweilige Zeitpunkt t0 kennzeichnet dabei jeweils den Beginn der Zeitdauer Δt, zu dem das Diagnosemodul 7 den Beginn des Aussendens eines Lichtsignals LS detektiert, wohingegen der jeweilige Zeitpunkt t1 das Ende des Aussendens des Lichtsignals LS repräsentiert. Der Zeitraum, bzw. die Zeitdauer zwischen t1 und t0 ist jeweils mit Δt gekennzeichnet. Die Auswerteeinheit 11 ist damit insbesondere dazu ausgebildet, aus den einzelnen aufbereiteten digitalen Lichtmesssignals ALMS, bzw. den aufbereiteten Signalimpulse SI jeweils eine Kennlinie gemäß den Figuren 4a bis 4d beispielweise mittels einer Anzeigeeinheit 18.2 abzubilden, die den Beginn t0 sowie das Ende t1 einer elektrischen Entladungserscheinung in Form eines Lichtbogens LS repräsentiert, und dabei aus der Amplitude und Lände der Kennlinie, also der Intensität I und der Zeitdauer Δt jeweiligen elektrischen Entladungserscheinung, direkte Rückschlüsse auf die Art der technischen Betriebsstörung, insbesondere um welche Art von Lichtbogen LB und/oder Teilentladung TE es sich handelt, zulässt.

Besonders bevorzugt weist dabei die Amplitude einer Kennlinie eines durch einen Störlichtbogen erzeugtes aufbereitetes digitales Lichtmesssignals ALMS, bzw. aufbereiteter Signalimpuls SI eine Intensität I auf, die näherungsweise doppelt so groß ist, wie die eines Schaltlichtbogens und/oder näherungsweise viermal so groß ausgebildet ist, wie die eines Prüflichtbogens und/oder näherungsweise 10⁹ mal so groß ausgebildet ist wie die einer Teilentladung TE. Weiterhin bevorzugt weist dabei die Länge einer Amplitude einer Kennlinie eines durch einen Störlichtbogen erzeugten aufbereiteten digitalen Lichtmesssignals ALMS, bzw. aufbereiteter Signalimpuls SI eine Zeitdauer Δt auf, die größer ist als die eines Schaltlichtbogens, die ihrerseits wiederum größer ist, als die eines Prüflichtbogens, die schließlich ihrerseits wiederum größer ist, als die von Teilentladungen TE.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegend Erfindungsgedanke verlassen wird.

### Bezugszeichenliste

- 1: Diagnosesystem
- 2: elektrische Hochspannungs- oder Mittelspannungsanlage
- 2.1: Innenraum
- 3: Gehäuse
- 4: Innenleiter
- 5: Anschlussflansch
- 6: Sichtfenster
- 7: Diagnosemodul
- 8: Lichtstab
- 9: optoelektrische Wandler- und Verstärkungseinheit
- 9a: erste optoelektrische Wandler- und Verstärkungseinheit
- 9b: zweite optoelektrische Wandler- und Verstärkungseinheit
- 10.1: erste Übertragungsleitung
- 10.2: zweite Übertragungsleitung
- 11: Auswerteeinheit
- 12: Anpassungsschaltung
- 12a: erste Anpassungsschaltung
- 12b: zweite Anpassungsschaltung
- 12.1: erster Anpassungsmesssignalpfad
- 12.1.1: erste Signalkonditionierungseinheit
- 12.1.2: erste Analog- Digital-Wandlereinheit
- 12.2: zweiter Anpassungsmesssignalpfad
- 12.2.1: zweite Signalkonditionierungseinheit
- 12.2.2: zweite Analog- Digital-Wandlereinheit
- 12a.1: erster Anpassungsmesssignalpfad
- 12a.1.1: erste Signalkonditionierungseinheit
- 12a.1.2: erste Analog- Digital-Wandlereinheit
- 12b.2: zweiter Anpassungsmesssignalpfad
- 12b.2.1: zweite Signalkonditionierungseinheit
- 12b.2.2: zweite Analog- Digital-Wandlereinheit
- 12.3: Umschalter
- 13: Spannungsversorgungseinheit
- 14: Steuereinheit
- 15: Steuerleitung
- 16: Schnittstelleneinheit
- 17: weitere Schnittstelleneinheit
- 18: Rechnereinheit
- 18.1: Anzeigeeinheit

- BM1: erster Betriebsmodus
- BM2: zweiter Betriebsmodus
- BS1: erste Betriebsspannung
- BS2: zweite Betriebsspannung

- AC: Wechselspannung
- ALMS*: aufbereitetes optisches Lichtmesssignal
- ALMS: aufbereitetes digitales Lichtmesssignal
- BM1: erster Betriebsmodus
- BM2: zweiter Betriebsmodus
- I: Intensität
- LS: Lichtsignal
- LMS: Lichtmesssignal
- RLS: Referenzlichtsignal
- Δt: Zeitdauer
- T0: Beginn Zeitdauer
- T1: Ende Zeitdauer
- LB: Lichtbogen
- SI: Signalimpuls
- TE: Teilentladung
- V: Spannungsverlauf

## Patentansprüche

1. System zur Diagnose des technischen Betriebszustandes einer elektrischen Hochspannungs- und Mittelspannungsanlage (2), die in zumindest einem gasdichten Innenraum (2.1) eines Gehäuses (3) wenigstens einen stromdurchflossenen Innenleiter (4) aufweist, bei dem zur optischen Erfassung eines durch elektrische Entladungserscheinungen in zumindest dem einen gasdichten Innenraum (2.1) des Gehäuses (3) erzeugten Lichtsignals (LS) ein Diagnosemodul (7) mit zumindest einer optoelektrischen Wandler- und Verstärkereinheit (9, 9a, 9b) vorgesehen ist, und wobei das Diagnosemodul (7) mit einer Auswerteeinheit (11) zusammenwirkt, wobei das Diagnosemodul (7) zur optischen Erfassung von Teilentladungen (TE) in einem ersten Betriebsmodus (BM1) sowie zur optischen Erfassung von Lichtbögen (LB) in einem zweiten Betriebsmodus (BM2) ausgebildet ist, wobei das durch die elektrische Entladungserscheinungen erzeugte Lichtsignal (LS) abhängig vom jeweiligen Betriebsmodus (BM1, BM2) unterschiedlich verstärkt und mittels der in dem Diagnosemodul (7) integrierten Auswerteeinheit (11) zur Diagnose des technischen Betriebszustandes unterschiedlich ausgewertet wird, **dadurch gekennzeichnet, dass** als zumindest eine optoelektrische Wandler- und Verstärkereinheit (9, 9a, 9b) ein Fotomultiplier verwendet wird, wobei die unterschiedliche Verstärkung des erzeugten Lichtsignals (LS) in beiden Betriebsmodi (BM1, BM2) durch eine unterschiedliche Betriebsspannung (BS1, BS2) des Fotomultipliers erzeugbar ist.

2. System nach Anspruch 1, **dadurch gekennzeichnet, dass** das Diagnosemodul (7) im Dauerbetrieb im zweiten Betriebsmodus (BM2) und während des Dauerbetriebs für eine vorgegebene Zeitdauer im ersten Betriebsmodus (BM1) betrieben wird.

3. System nach Anspruch 1 oder 2, **dadurch gekennzeichnet, dass** die optische Wandler- und Verstärkereinheit (9) des Diagnosemoduls (7) mit einer Spannungsversorgungseinheit (13) zusammenwirkt, mittels der die optoelektrische Wandler- und Verstärkungseinheit (9) mit wenigstens zwei unterschiedlichen Betriebsspannungen (BS1, BS2) beaufschlagbar ist.

4. System nach Anspruch 3, **dadurch gekennzeichnet, dass** die Spannungsversorgungseinheit (13) zwischen den mindestens zwei Betriebsspannungen (BS1, BS2) umschaltbar ist.

5. System nach Anspruch 4, **dadurch gekennzeichnet, dass** das Diagnosemodul (7) in dem ersten Betriebsmodus (BM1) mit der ersten Betriebsspannung (BS1) der Spannungsversorgungseinheit (13) betrieben wird und/oder das Diagnosemodul (7) in dem zweiten Betriebsmodus (BM2) mit einer zweiten Betriebsspannung (BS2) der Spannungsversorgungseinheit (13) betrieben wird.

6. System nach einem der vorhergehenden Ansprüche 1 bis 5, **dadurch gekennzeichnet, dass** das Diagnosemodul (7) eine Anpassungsschaltung (12) mit einem ersten und einem zweiten Anpassungsmesssignalpfad (12.1, 12.2) aufweist, die abhängig vom jeweiligen Betriebsmodus (BM1, BM2) geschaltet sind.

7. System nach Anspruch 6, **dadurch gekennzeichnet, dass** im ersten Betriebsmodus (BM1) der erste Anpassungsmesssignalpfad (12.1) beschaltet ist und/oder im zweiten Betriebsmodus (BM2) der zweite Anpassungsmesssignalpfad (12.2) beschaltet ist.

8. System nach einem der vorhergehenden Ansprüche 1 bis 7, **dadurch gekennzeichnet, dass** das Diagnosemodul (7) dazu eingerichtet ist, zwischen dem ersten und dem zweiten Anpassungsmesssignalpfad (12.1, 12.2) abhängig vom jeweiligen Betriebsmodus (BM1, BM2) mittels eines Umschalters (12.3) gesteuert umzuschalten.

9. System nach einem der vorhergehenden Ansprüche 1 bis 8, **dadurch gekennzeichnet, dass** das Diagnosemodul (7) wenigstens einen Lichtstab (8) aufweist, der dazu ausgebildet ist, das Lichtsignal (LS) wenigstens des Innenraums(2.1)des Gehäuses (3) zu erfassen und an die zumindest eine optoelektrische Wandler- und Verstärkereinheit (9) zu übertragen.

10. System nach einem der vorhergehenden Ansprüche 1 bis 9, **dadurch gekennzeichnet, dass** die zumindest eine optoelektrische Wandler- und Verstärkereinheit (9) dazu ausgebildet ist, das Lichtsignal (LS) abhängig vom jeweiligen Betriebsmodus (BM1, BM2) unterschiedlich zu verstärken und in ein analoges elektrisches Lichtmesssignal (LMS) umzuwandeln.

11. System nach einem der Ansprüche 6 bis 10, **dadurch gekennzeichnet, dass** die Anpassungsschaltung (12) dazu eingerichtet ist, das von der zumindest einen optoelektrischen Wandler- und Verstärkereinheit (9) ankommende analoge Lichtmesssignal (LMS) in Abhängigkeit des Betriebsmodus (BM1, BM2) des Diagnosemoduls (7) in ein aufbereitetes digitales Lichtmesssignal (ALMS) umzuwandeln, das mittels der zumindest einen Auswerteeinheit (11) zur Diagnose des technischen Betriebszustandes in Abhängigkeit des jeweiligen Betriebsmodus (BM1, BM2) unterschiedlich ausgewertet wird.

12. System nach Anspruch 11, **dadurch gekennzeichnet, dass** das aufbereitete Lichtmesssignal (ALMS, ALMS*) im Spannungs-Nulldurchgang der positiven Halbwelle des mit einer Wechselspannung (AC) beaufschlagten stromdurchflossenen Innenleiters (4) erfolgt.

13. System nach einem der Ansprüche 1 bis 12, **dadurch gekennzeichnet, dass** das Diagnosemodul (7) zur optischen Erfassung von Teilentladungen (TE) mittels einer ersten optoelektrischen Wandler- und Verstärkereinheit (9a) sowie zur optischen Erfassung von Störlichtbögen (SB) mittels einer zweiten optoelektrischen Wandler- und Verstärkereinheit (9b) ausgebildet ist, wobei das durch die elektrische Entladungserscheinungen erzeugte Lichtsignal (LS) in den beiden optoelektrischen Wandler- und Verstärkereinheiten (9a, 9b) unterschiedlich verstärkt und mittels der zumindest einen Auswerteeinheit (11) zur Diagnose des technischen Betriebszustandes unterschiedlich ausgewertet wird.

14. System nach Anspruch 13, **dadurch gekennzeichnet, dass** das Diagnosemodul (7) eine erste und eine zweite optoelektrischen Wandler- und Verstärkereinheit (9a, 9b) aufweist, wobei die erste optoelektrische Wandler- und Verstärkereinheit (9a) als Fotomultiplier und die zweite optoelektrische Wandler- und Verstärkereinheit (9b) als Fotodiode ausgebildet ist.

15. System nach einem der vorhergehenden Ansprüche 1 bis 14, **gekennzeichnet durch** ein gesteuert betätigbares Leuchtmittel zur Erzeugung eines Lichtsignals LS zur Eigendiagnose des Systems.

## Claims

1. A system for diagnosing the technical operating state of an electrical high-voltage and medium-voltage installation (2) having at least one current-carrying inner conductor (4) in at least one gas-tight interior (2.1) of a housing (3), wherein a diagnostic module (7) comprising at least an opto-electrical converter and amplifier unit (9, 9a, 9b) is provided for the optical detection of a light signal (LS) generated by electrical discharge phenomena in the at least one gas-tight interior (2.1) of the housing (3), and wherein the diagnostic module (7) interacts with an evaluation unit (11), wherein the diagnostic module (7) is designed for optical detection of partial discharges (TE) in a first operating mode (BM1) and for optical detection of arcs (LB) in a second operating mode (BM2), wherein the light signal (LS) generated by the electrical discharge phenomena is amplified differently depending on the respective operating mode (BM1, BM2) and is evaluated differently by means of the evaluation unit (11) integrated in the diagnostic module (7) for diagnosing the technical operating state, **characterized in that** a photomultiplier is used as at least one opto-electrical converter and amplifier unit (9, 9a, 9b), wherein the different amplification of the generated light signal (LS) in the two operating modes (BM1, BM2) is generatable by a different operating voltage (BS1, BS2) of the photomultiplier.

2. System according to claim 1, **characterized in that** the diagnostic module (7) is operated in continuous operation in the second operating mode (BM2) and for a predetermined time period during the continuous operation in the first operating mode (BM1).

3. System according to claim 1 or 2, **characterized in that** the optical converter and amplifier unit (9) of the diagnostic module (7) interacts with a voltage supply unit (13) by means of which at least two different operating voltages (BS1, BS2) can be applied to the opto-electrical converter and amplifier unit (9).

4. System according to claim 3, **characterized in that** the voltage supply unit (13) is switchable between the at least two operating voltages (BS1, BS2).

5. System according to claim 4, **characterized in that** the diagnostic module (7) is operated with the first operating voltage (BS1) of the voltage supply unit (13) in the first operating mode (BM1) and/or the diagnostic module (7) is operated with a second operating voltage (BS2) of the voltage supply unit (13) in the second operating mode (BM2).

6. System according to one of preceding claims 1 to 5, **characterized in that** the diagnostic module (7) comprises a matching circuit (12) having a first and a second matching measuring signal path (12.1, 12.2) which are connected depending on the respective operating mode (BM1, BM2).

7. System according to claim 6, **characterized in that** the first matching measuring signal path (12.1) is connected in the first operating mode (BM1) and/or the second matching measuring signal path (12.2) is connected in the second operating mode (BM2).

8. System according to one of preceding claims 1 to 7, **characterized in that** the diagnostic module (7) is equipped to switch in a controlled way by means of a changeover switch (12.3) between the first and the second matching measuring signal path (12.1, 12.2) depending on the respective operating mode (BM1, BM2).

9. System according to one of preceding claims 1 to 8, **characterized in that** the diagnostic module (7) comprises at least one light bar (8) which is designed to detect the light signal (LS) of at least the interior (2.1) of the housing (3) and to transmit said light signal to the at least one opto-electrical converter and amplifier unit (9).

10. System according to one of preceding claims 1 to 9, **characterized in that** the at least one opto-electrical converter and amplifier unit (9) is designed to amplify the light signal (LS) differently depending on the respective operating mode (BM1, BM2) and to convert said light signal into an analog electrical light measurement signal (LMS).

11. System according to one of preceding claims 6 to 10, **characterized in that** the matching circuit (12) is equipped to convert the analog light measurement signal (LMS) arriving from the at least one opto-electrical converter and amplifier unit (9), depending on the operating mode (BM1, BM2) of the diagnostic module (7), into a conditioned digital light measurement signal (ALMS), which is evaluated differently by means of the at least one evaluation unit (11) for diagnosing the technical operating state depending on the respective operating mode (BM1, BM2).

12. System according to claim 11, **characterized in that** the conditioned light measurement signal (ALMS, ALMS*) is carried out at the zero voltage crossing of the positive half-cycle of the current-carrying inner conductor (4) supplied with an alternating voltage (AC).

13. System according to one of preceding claims 1 to 12, **characterized in that** the diagnostic module (7) is designed for the optical detection of partial discharges (TE) by means of a first opto-electrical converter and amplifier unit (9a) and for the optical detection of fault arcs (SB) by means of a second opto-electrical converter and amplifier unit (9b), wherein the light signal (LS) generated by the electrical discharge phenomena is amplified differently in the two opto-electrical converter and amplifier units (9a, 9b) and is evaluated differently by means of the at least one evaluation unit (11) for diagnosing the technical operating state.

14. System according to claim 13, **characterized in that** the diagnostic module (7) comprises a first and a second opto-electrical converter and amplifier unit (9a, 9b), wherein the first opto-electrical converter and amplifier unit (9a) is designed as a photomultiplier and the second opto-electrical converter and amplifier unit (9b) is designed as a photodiode.

15. System according to one of preceding claims 1 to 14, **characterized by** a controllably actuatable lighting means for generating a light signal (LS) for self-diagnosis of the system.

## Revendications

1. Système de diagnostic de l'état de fonctionnement technique d'une installation électrique haute tension et moyenne tension (2), qui comporte au moins un conducteur intérieur (4) traversé par du courant dans au moins un espace intérieur (2.1) étanche aux gaz d'un boîtier (3), pour lequel un module de diagnostic (7) avec au moins une unité de convertisseur et d'amplificateur optoélectrique (9, 9a, 9b) est prévu pour la saisie optique d'un signal lumineux (LS) généré par des phénomènes de décharge électriques dans au moins l'un espace intérieur (2.1) étanche aux gaz du boîtier (3), le module de diagnostic (7) coopérant avec une unité d'évaluation (11), le module de diagnostic (7) étant constitué pour la saisie optique de décharges partielles (TE) dans un premier mode de fonctionnement (BM1) ainsi que pour la saisie optique d'arcs électriques (LB) dans un deuxième mode de fonctionnement (BM2), le signal lumineux (LS) généré par les phénomènes de décharge électriques étant différemment amplifié en fonction du mode de fonctionnement respectif (BM1, BM2) et exploité différemment au moyen de l'unité d'évaluation (11) intégrée dans le module de diagnostic (7) pour le diagnostic de l'état de fonctionnement technique, **caractérisé en ce que** l'on utilise un photomultiplicateur en tant qu'au moins une unité de convertisseur et d'amplificateur optoélectrique (9, 9a, 9b), l'amplification différente du signal lumineux généré (LS) pouvant être générée dans les deux modes de fonctionnement (BM1, BM2) par une tension de fonctionnement différente (BS1, BS2).

2. Système selon la revendication 1, **caractérisé en ce que** le module de diagnostic (7) est utilisé en fonctionnement continu en deuxième mode de fonctionnement (BM2) et dans le premier mode de fonctionnement (BM1) pendant le fonctionnement continu pour une période de temps prédéfinie.

3. Système selon la revendication 1 ou 2, **caractérisé en ce que** l'unité de convertisseur et d'amplificateur (9) du module de diagnostic (7) coopère avec une unité d'alimentation en tension (13) au moyen de laquelle l'unité de convertisseur et d'amplification (9) peut être sollicitée avec au moins deux tensions de fonctionnement différentes (BS1, BS2).

4. Système selon la revendication 3, **caractérisé en ce que** l'unité d'alimentation en tension (13) peut être commutée entre au moins les deux tensions de fonctionnement (BS1, BS2).

5. Système selon la revendication 4, **caractérisé en ce que** le module de diagnostic (7) est utilisé dans le premier mode de fonctionnement (BM1) avec la première tension de fonctionnement (BS1) de l'unité d'alimentation en tension (13) et/ou le module de diagnostic (7) est utilisé dans le deuxième mode de fonctionnement (BM2) avec une deuxième tension de fonctionnement (BS2) de l'unité d'alimentation en tension (13).

6. Système selon l'une quelconque des revendications précédentes 1 à 5, **caractérisé en ce que** le module de diagnostic (7) comporte un circuit d'adaptation (12) avec un premier et un deuxième chemin de signal de mesure d'adaptation (12.1, 12.2), qui sont connectés en fonction du mode de fonctionnement respectif (BM1, BM2).

7. Système selon la revendication 6, **caractérisé en ce que** dans le premier mode de fonctionnement (BM1), le premier chemin de signal de mesure d'adaptation (12.1) est connecté et/ou dans le deuxième mode de fonctionnement (BM2), le deuxième chemin de signal de mesure d'adaptation (12.2) est connecté.

8. Système selon l'une quelconque des revendications précédentes 1 à 7, **caractérisé en ce que** le module de diagnostic (7) est agencé pour commuter entre le premier et le deuxième chemin de signal de mesure d'adaptation (12.1, 12.2) en fonction du mode de fonctionnement respectif (BM1, BM2), piloté au moyen d'un inverseur (12.3).

9. Système selon l'une quelconque des revendications précédentes 1 à 8, **caractérisé en ce que** le module de diagnostic (7) comporte au moins une barre lumineuse (8), qui est constituée pour saisir le signal lumineux (LS) au moins de l'espace intérieur (2.1) du boîtier (3) et transmettre à au moins une unité de convertisseur et d'amplificateur optoélectrique (9).

10. Système selon l'une quelconque des revendications précédentes 1 à 9, **caractérisé en ce qu'**au moins une unité de convertisseur et d'amplificateur optoélectrique (9) est constituée pour amplifier différemment le signal lumineux (LS) en fonction du mode de fonctionnement respectif (BM1, BM2) et convertir en un signal de mesure lumineux (LMS) électrique analogique.

11. Système selon l'une quelconque des revendications 6 à 10, **caractérisé en ce que** le circuit d'adaptation (12) est agencé pour convertir le signal de mesure lumineux (LMS) analogique venant d'au moins une unité de convertisseur et amplificateur optoélectrique (9) en fonction du mode de fonctionnement (BM1, BM2) du module de diagnostic (7) en un signal de mesure lumineux numérique traité (ALMS), qui est évalué différemment au moyen d'au moins une unité d'évaluation (11) pour diagnostic de l'état de fonctionnement technique en fonction du mode de fonctionnement respectif (BM1, BM2).

12. Système selon la revendication 11, **caractérisé en ce que** le signal de mesure lumineux traité (ALMS, ALMS*) a lieu dans un passage par zéro de tension de la demi-onde positive du conducteur intérieur (4) traversé par un courant sollicité par une tension alternative (AC).

13. Système selon l'une quelconque des revendications 1 à 12, **caractérisé en ce que** le module de diagnostic (7) est constitué pour la saisie optique de décharges partielles (TE) au moyen d'une première unité de convertisseur et d'amplificateur optoélectrique (9a) ainsi que pour la saisie optique d'arcs électriques parasites (SB) au moyen d'une deuxième unité de convertisseur et d'amplificateur optoélectrique (9b), le signal lumineux (LS) généré par les phénomènes de décharge électriques étant différemment amplifié dans les deux unités de convertisseur et d'amplificateur optoélectriques (9a, 9b) et différemment évalué au moins au moyen de l'unité d'évaluation (11) pour le diagnostic de l'état de fonctionnement technique.

14. Système selon la revendication 13, **caractérisé en ce que** le module de diagnostic (7) comporte une première et une deuxième unité de convertisseur et d'amplificateur optoélectrique (9a, 9b), la première unité de convertisseur et d'amplificateur optoélectrique (9a) étant constituée comme photomultiplicateur et la deuxième unité de convertisseur et d'amplificateur optoélectrique (9b) comme photodiode.

15. Système selon l'une quelconque des revendications précédentes 1 à 14, **caractérisé par** un moyen lumineux actionnable de façon asservie pour générer un signal lumineux (LS) pour un diagnostic propre du système.
